(19) Europäisches Patentamt / European Patent Office / Office européen des brevets

(11) **EP 4 764 527 A1**

(12) **EUROPEAN PATENT APPLICATION**
published in accordance with Art. 153(4) EPC

(43) Date of publication:
**24.06.2026 Bulletin 2026/26**

(21) Application number: **25864151.3**

(22) Date of filing: **05.09.2025**

(51) International Patent Classification (IPC):
**G01R 31/367** (2019.01)   **G01R 31/36** (2020.01)
**G01R 31/396** (2019.01)   **G01R 31/392** (2019.01)
**G01R 31/382** (2019.01)   **H02J 7/00** (2026.01)

(52) Cooperative Patent Classification (CPC):
**G01R 31/36; G01R 31/367; G01R 31/382;
G01R 31/392; G01R 31/396; H02J 7/00**

(86) International application number:
**PCT/KR2025/013813**

(87) International publication number:
**WO 2026/054588 (12.03.2026 Gazette 2026/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.09.2024 KR 20240121713**

(71) Applicant: **LG Energy Solution, Ltd.
Seoul 07335 (KR)**

(72) Inventors:
• **CHOI, Jeong Hyeon**
 **Daejeon 34122 (KR)**
• **JEONG, Yu Na**
 **Daejeon 34122 (KR)**
• **KANG, Seo Hee**
 **Daejeon 34122 (KR)**

(74) Representative: **Plasseraud IP
104 Rue de Richelieu
CS92104
75080 Paris Cedex 02 (FR)**

(54) **BATTERY DIAGNOSIS DEVICE AND METHOD THEREFOR**

(57)    A battery diagnosis device according to an embodiment of this document includes a memory in which one or more instructions are stored and a processor configured to execute the one or more instructions, and the processor is configured to acquire an equivalent cycle of the battery based on the battery being discharged for a first designated duration and predict the life of the battery when the battery is operated in a designated mode based on at least one of a first discharge energy used until the battery degrades by a designated percentage, a second discharge energy usable by the battery for a second designated duration, the equivalent cycle, or any combination thereof.

BATTERY DIAGNOSIS DEVICE
200

PROCESSOR
210

MEMORY
220

FIG.2

EP 4 764 527 A1

**Description**

## TECHNICAL FIELD

### Cross-reference to Related Applications

This application claims priority from Korean Patent Application No. 10-2024-0121713, filed on September 6, 2024, the disclosure of which is incorporated by reference herein.

### Technical Field

Embodiments disclosed in this document relate to a battery diagnosis device and battery diagnosis method.

## BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, secondary batteries have been receiving attention as a next-generation energy storage medium, as their scope of use has expanded to include power sources for electric vehicles.

The battery may be operated in various modes. Among the modes in which the battery operates, the frequency regulation mode (FR mode) is used to stabilize the frequency, and may be a mode that stabilizes the frequency by supplying power when demand is high and charging the battery when demand is low. In this case, the actual amount of energy used by the battery is not linear due to frequency fluctuations, and thus it is difficult to predict the life of the battery. Therefore, even when the battery operates in a frequency regulation mode, various studies are being conducted to predict the life of the battery.

## DISCLOSURE OF THE INVENTION

## TECHNICAL PROBLEM

Embodiments provide a battery diagnosis device and battery diagnosis method for accurately predicting the life of a battery in an environment where the SOC of the battery continuously changes.

Embodiments provide a battery diagnosis device and battery diagnosis method for predicting the life of a battery by reflecting the characteristics of the frequency regulation mode while the battery is operated in the frequency regulation mode.

Embodiments provide a battery diagnosis device and battery diagnosis method for accurately predicting the life of a battery by analyzing patterns identified in a frequency regulation mode and predicting the life of the battery.

The technical problems of the present invention are not limited to the technical problems mentioned above, and other technical problems that are not mentioned may be clearly understood by those skilled in the art from the descriptions below.

## TECHNICAL SOLUTION

A battery diagnosis device according to an embodiment of this document includes a memory in which one or more instructions are stored and a processor configured to execute the one or more instructions, and the processor is configured to acquire an equivalent cycle of the battery based on the battery being discharged for a first designated duration and predict the life of the battery when the battery is operated in a designated mode based on at least one of a first discharge energy used until the battery degrades by a designated percentage, a second discharge energy usable by the battery for a second designated duration, the equivalent cycle, or any combination thereof.

In an embodiment, the processor may be configured to predict the life of the battery based on a ratio of the first discharge energy to the second discharge energy.

In an embodiment, the processor may be configured to acquire the first discharge energy based on at least one of a state of charge (SOC) of the battery, a temperature of the battery, constant power (CP) of the battery, energy of the battery, or any combination thereof.

In an embodiment, the processor may be configured to acquire the equivalent cycle based on data associated with the SOC of the battery identified while the battery is discharged in the designated mode.

In an embodiment, the designated mode may include a frequency regulation (FR) mode.

In an embodiment, the processor may be configured to acquire a weight for predicting the life of the battery based on the equivalent cycle associated with power used when charging or discharging the battery.

In an embodiment, the processor may be configured to predict the life based on applying the weight to the second discharge energy.

In an embodiment, the processor may be configured to acquire the second discharge energy using a designated calculation formula.

A battery diagnosis method according to an embodiment of this document includes an operation of acquiring, by a processor, an equivalent cycle of the battery based on the battery being discharged for a first designated duration and an operation of predicting, by the processor, the life of the battery when the battery is operated in a designated mode based on at least one of a first discharge energy used until the battery degrades by a designated percentage, a second discharge energy usable by the battery for a second designated duration, the equivalent cycle, or any combination thereof.

The battery diagnosis method according to an embodiment may include an operation of predicting, by the processor, the life of the battery based on a ratio of the first discharge energy to the second discharge energy.

The battery diagnosis method according to an embodiment may include an operation of acquiring, by the processor, the first discharge energy based on at least one of a state of charge (SOC) of the battery, a temperature of the battery, constant power (CP) of the battery, energy of the battery, or any combination thereof.

The battery diagnosis method according to an embodiment may include an operation of acquiring, by the processor, the equivalent cycle based on data associated with the SOC of the battery identified while the battery is discharged in the designated mode.

In an embodiment, the designated mode may include a frequency regulation (FR) mode.

The battery diagnosis method according to an embodiment may include an operation of predicting, by the processor, the life of the battery based on the equivalent cycle associated with power used when charging or discharging the battery.

The battery diagnosis method according to an embodiment may include an operation of predicting, by the processor, the life based on applying the weight to the second discharge energy.

## ADVANTAGEOUS EFFECTS

The present technology can accurately predict the life of the battery in an environment where the SOC of the battery continuously changes.

The present technology can predict the life of a battery by reflecting the characteristics of the frequency regulation mode while the battery is operated in the frequency regulation mode.

The present technology can accurately predict the life of the battery by analyzing patterns identified in the frequency regulation mode and predicting the life of the battery.

In addition, various effects that are directly or indirectly identified through this document can be provided.

## BRIEF DESCRIPTION OF THE DRAWINGS

FIG. 1 is a block diagram illustrating a battery pack, in a battery diagnosis device and battery diagnosis method according to an embodiment of this document.

FIG. 2 illustrates an example of a block diagram illustrating a configuration of a battery diagnosis device according to an embodiment of this document.

FIG. 3a illustrates an example of a graph related to an amount of change in SOC of a battery over time in an embodiment of this document.

FIG. 3b illustrates an example of a graph related to an amount of change in SOC of a battery over time in an embodiment of this document.

FIG. 4a illustrates an example of a graph related to an amount of change in SOC of a battery over time in an embodiment of this document.

FIG. 4b illustrates an example of a graph related to equivalent cycles of a battery over time in an embodiment of this document.

FIG. 4c illustrates an example of a graph related to an amount of change in SOC of a battery over time in an embodiment of this document.

FIG. 5 illustrates an example of a flowchart related to a battery diagnosis method according to an embodiment of this document.

FIG. 6 is a block diagram illustrating a hardware configuration of a computing system that performs a battery diagnosis method, in a battery diagnosis device and the battery diagnosis method according to an embodiment of this document.

## MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

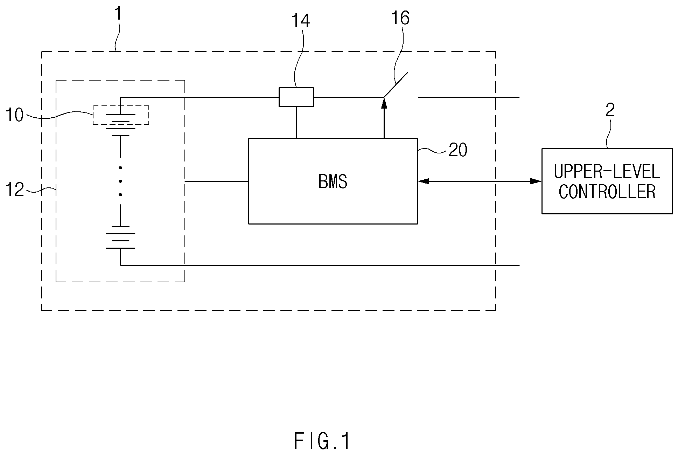

Hereinafter, embodiments of this document will be described in detail with reference to FIGS. 1 to 6.

FIG. 1 is a block diagram illustrating a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 12 may include at least one battery cell 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharging and overdischarging, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

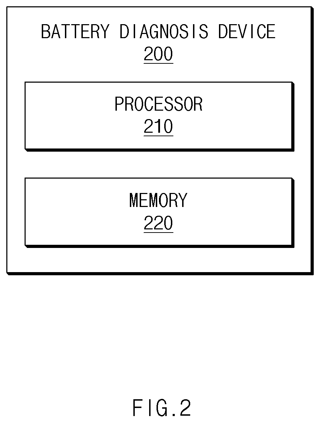

According to an embodiment, the battery management system 20 may include a battery diagnosis device 200 of FIG. 2. According to another embodiment, the battery management system 20 may be a different system from the battery diagnosis device 200 of FIG. 2. That is, the battery diagnosis device 200 of FIG. 2 may be included in the battery pack 1 or may be configured as another device external to the battery pack 1. Hereinafter, for convenience of description, the description will be made on the assumption that the battery diagnosis device 200 is configured as another device external to the battery pack 1. In addition, the operation of the battery diagnosis device 200 described below may be performed by a BMS in the vehicle, and may also be performed by various devices such as a server, a cloud, a charger, or a discharger.

FIG. 2 illustrates an example of a block diagram illustrating the configuration of a battery diagnosis device according to an embodiment of this document.

Referring to FIG. 2, the battery diagnosis device 200 according to an embodiment may include a processor 210 and a memory 220. The processor 210 and the memory 220 may be electrically and/or operably coupled with each other by an electronic component including a communication bus.

Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware.

Although pieces of hardware are illustrated in different blocks, embodiments are not limited thereto. For example, some of the pieces of hardware of FIG. 2 may be included in a single integrated circuit including a system on a chip (SoC). The type and/or number of pieces of hardware included in the battery diagnosis device 200 is not limited to that shown in FIG. 2. For example, the battery diagnosis device 200 may include only some pieces of the hardware shown in FIG. 2.

The battery diagnosis device 200 according to an embodiment may include hardware for processing data based on one or more instructions. The hardware for processing data may include the processor 210.

For example, hardware for processing data may include an arithmetic and logic unit (ALU), a floating point unit (FPU), a field programmable gate array (FPGA), a central processing unit (CPU), and/or an application processor (AP). The processor 210 may have a single-core processor architecture or a multi-core processor architecture having dual cores, quad cores, hexa cores, or octa cores.

The memory 220 of the battery diagnosis device 200 according to an embodiment may include hardware components for storing data and/or instructions input and/or output to and from the processor 210 of the battery diagnosis device 200.

For example, the memory 220 may include a volatile memory including a random-access memory (RAM) and/or a non-volatile memory including a read-only memory (ROM).

For example, the volatile memory may include at least one of dynamic RAM (DRAM), static RAM (SRAM), cache RAM, pseudo SRAM (PSRAM), or any combination thereof.

For example, the non-volatile memory may include at least one of a programmable ROM (PROM), an erasable PROM (EPROM), an electrically erasable PROM (EEPROM), a flash memory, a hard disk, a compact disc, a solid state drive (SSD), an embedded multi-media card (eMMC), or any combination thereof.

For example, at least one instruction (or command) indicating operations and/or actions to be performed on data by the processor 210 of the battery diagnosis device 200 may be stored in the memory 220 of the battery diagnosis device 200. A set of one or more instructions may be referred to as a program, firmware, operating system, process, routine, subroutine, and/or application. Hereinafter, the installation of an application in the battery diagnosis device 200 may mean that at least one instruction provided in the form of an application is stored in the memory 220, and that the application is stored in an executable format (e.g., a file having an extension designated by an operating system of the battery diagnosis device 200) by the processor 210 of the battery diagnosis device 200.

The processor 210 of the battery diagnosis device 200 according to an embodiment may acquire an equivalent cycle of the battery based on the battery being discharged for a first a designated duration. For example, the equivalent cycle of a battery may be related to at least one of the energy consumed while the battery is discharged, the change in the state of charge (SOC) while the battery is discharged, or any combination thereof.

For example, the first designated duration may include 24 hours. However, the embodiments of this document are not limited to that described above. For example, the first designated duration may include 24 hours, 1 week, 30 days, or any combination thereof, and the first designated duration may include a duration that is shorter than a second designated duration described below.

The processor 210 of the battery diagnosis device 200 according to an embodiment may identify at least one of a first discharge energy used until the battery degrades by a designated percentage, a second discharge energy usable by the battery for the second designated duration, an equivalent cycle, or any combination thereof.

For example, the processor 210 may acquire first discharge energy based on at least one of the SOC of the battery, the temperature of the battery, the constant power (CP) of the battery, the energy of the battery, or any combination thereof.

For example, the processor 210 may acquire second discharge energy usable for the second designated duration using a designated calculation formula. For example, the second designated duration may include a duration longer than the first designated duration. For example, the second designated duration may include approximately one year. However, the embodiments of this document are not limited to those described above.

For example, the processor 210 may acquire an equivalent cycle based on data associated with the SOC of the battery identified while the battery is being discharged in a designated mode.

For example, the CP may mean a value for charging or discharging a battery with a designated power. For example, when the battery is charged by setting the CP to 0.25, the battery may be charged at a rate of 25% per hour. For example, when the battery is discharged by setting the CP to 0.25, the battery may be discharged at a rate of 25% per hour. Thus, when the CP is 0.25, the battery is fully charged over four hours and may be fully discharged over four hours. In this case, the battery may be fully charged and fully discharged three times a day, and the equivalent cycle of the battery may be 3.

For example, the processor 210 may predict the life of the battery when the battery is operated in a designated mode based on at least one of the first discharge energy used until the battery degrades by the designated percentage, a second discharge energy usable by the battery for the second designated duration, the equivalent cycle, or any combination thereof.

For example, the designated percentage may include approximately 90%. However, the embodiments of this document are not limited to that described above.

For example, the processor 210 may predict the life of the battery when the battery is operated in the designated mode based on the first discharge energy, the second discharge energy, and the equivalent cycle.

For example, the designated mode may include a frequency regulation (FR) mode.

For example, a frequency regulation mode may include a mode that detects a variation in frequency and regulates charging or discharging as needed to maintain the frequency.

For example, the processor 210 may predict the life of the battery based on a ratio of the first discharge energy to the second discharge energy. For example, the ratio of the first discharge energy to the second discharge energy can be expressed as 'first discharge energy/second discharge energy'.

For example, the processor 210 may acquire a weight for predicting the life of the battery based on the equivalent cycle associated with the power used when charging or discharging the battery. As described above, the equivalent cycle may be associated with the power used when charging or discharging the battery, i.e. the CP. For example, the weight may include a value corresponding to the equivalent cycle. For example, when the equivalent cycle is 3, the weight may be 3. However, the embodiments of this document are not limited to those described above.

For example, the processor 210 may predict the life of the battery based on applying the weight for predicting the life of the battery to the second discharge energy.

Specifically, the processor 210 may predict the life of the battery using Equation 1 below.

[Equation 1]

$$Battery\ life = \frac{first\ discharge\ energy}{second\ discharge\ energy \times weight}$$

Referring to Equation 1, the first discharge energy may include the discharge energy of the battery used until the battery is degraded by the designated percentage (e.g., approximately 90%). The second discharge energy may include the discharge energy of the battery that can be used for the second designated duration (e.g., approximately one year). The weight may include values that are substantially equal to the equivalent cycle.

As described above, the battery diagnosis device 200 according to an embodiment may acquire the equivalent cycle of the battery and predict the life of the battery based on the weight acquired using the equivalent cycle. Specifically, the battery diagnosis device 200 may predict the life of the battery using the first discharge energy of the battery, the second discharge energy of the battery, and the equivalent cycle.

As described above, the battery diagnosis device 200 may accurately predict the life of the battery even when the battery is operated in the designated mode (e.g., the frequency regulation mode) by predicting the life of the battery using the first discharge energy, the second discharge energy, and the equivalent cycle of the battery.

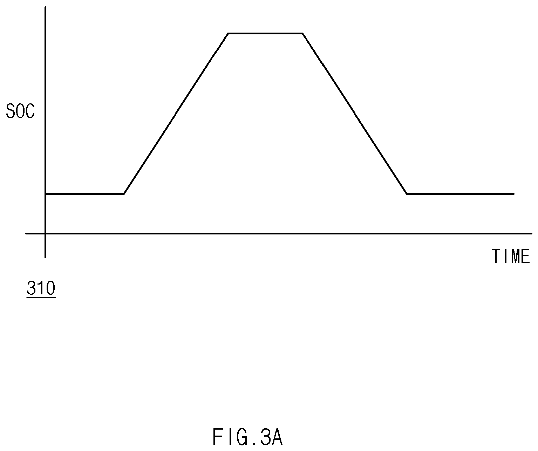

FIG. 3a illustrates an example of a graph related to an amount of change in SOC of a battery over time in an embodiment of this document.

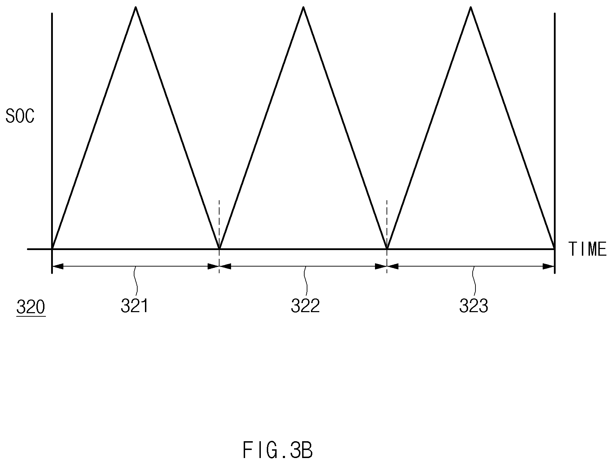

Referring to FIG. 3, the processor 210 of the battery diagnosis device 200 according to an embodiment may acquire data associated with the SOC of the battery while the battery is operated in a mode different from the designated mode (e.g., the frequency regulation mode) described in FIG. 1.

For example, the mode different from the designated mode may include a power saving (PS) mode.

Referring to a graph 310 of FIG. 3a, it can be seen that the SOC change of the battery is relatively linear in the PS mode.

In the graph 310 illustrated in FIG. 3a, the lowest SOC value may be approximately 5, and the highest SOC value may be approximately 95. In addition, the graph 310 may mean the amount of change in SOC of the battery when the CP is 0.25 and the battery is operated in the PS mode.

FIG. 3b illustrates an example of a graph related to an amount of change in SOC of a battery over time in an embodiment of this document.

Referring to FIG. 3b, the processor 210 of the battery diagnosis device 200 according to an embodiment may calculate the cycle for a reference time (e.g., approximately 24 hours) using the amount of change in the SOC of the battery over time.

A graph 320 of FIG. 3b may include a graph showing the amount of change in SOC of the battery while charging and/or discharging the battery by setting the CP to 0.25.

Referring to the graph 320, it can be seen that the battery is fully charged and fully discharged in a plurality of time intervals 321, 322, and 323.

For example, the first time interval 321, the second time interval 322, and the third time interval 323 may be intervals having substantially the same length.

For example, when the CP is set to 0.25, it takes approximately 4 hours to fully charge the battery and approximately 4 hours to fully discharge the battery, and thus the first time interval 321, the second time interval 322, and the third time interval 323 may each be approximately 8 hours.

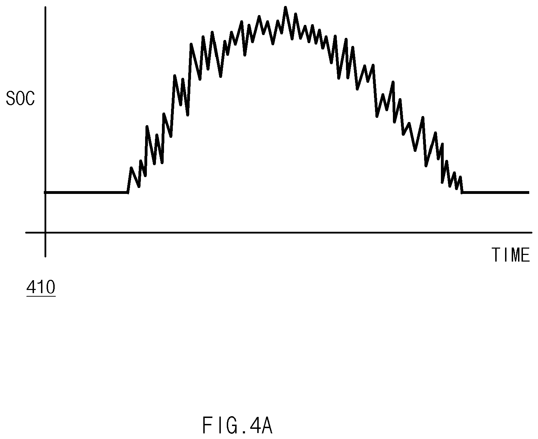

FIG. 4a illustrates an example of a graph related to an amount of change in SOC of a battery over time in an embodiment of this document.

Referring to FIG. 4a, the processor 210 of the battery diagnosis device 200 according to an embodiment may acquire data associated with the SOC of the battery while the battery is operated in the designated mode (e.g., the frequency regulation mode).

Referring to a graph 410 of FIG. 4a, it can be seen that the SOC change of the battery is irregular in the frequency regulation mode.

In a graph 410 illustrated in FIG. 4a, the lowest SOC value may be approximately 5, and the highest SOC value may be approximately 95. In addition, the graph 410 may mean the amount of change in SOC of the battery that appears when the CP is set to 0.25, and the battery operates in the frequency regulation mode.

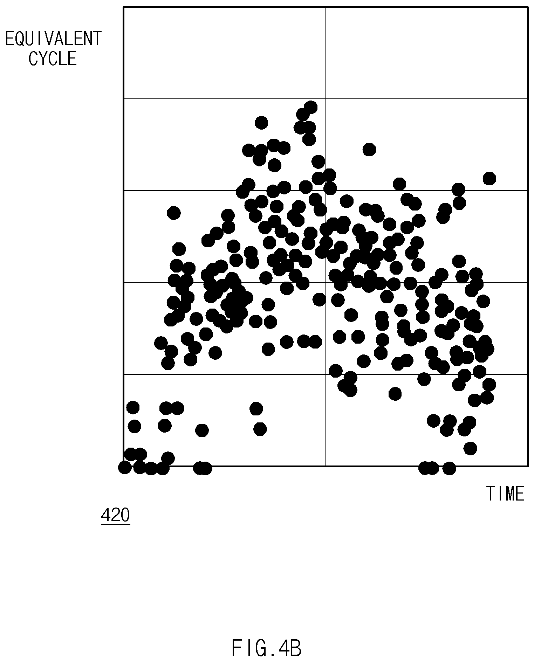

FIG. 4b illustrates an example of a graph related to equivalent cycles of a battery over time in an embodiment of this document.

Referring to FIG. 4b, the processor 210 of the battery diagnosis device 200 according to an embodiment may acquire a daily equivalent cycle of the battery. For example, the processor 210 of the battery diagnosis device 200 according to an embodiment may acquire the equivalent cycle of the battery that changes over time.

A graph 420 may include an example showing equivalent cycles acquired over time.

In an embodiment, the processor 210 may acquire the weight used when predicting the life of the battery using data related to the equivalent cycle including the graph 420. For example, the weight may have a value corresponding to the equivalent cycle.

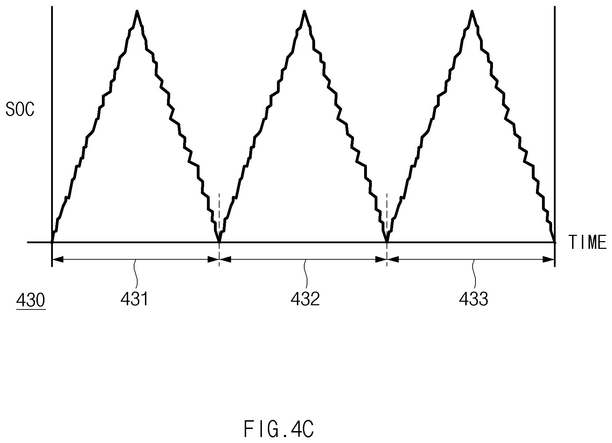

FIG. 4c illustrates an example of a graph related to an amount of change in SOC of a battery over time in an embodiment of this document.

Referring to FIG. 4c, the processor 210 of the battery diagnosis device 200 according to an embodiment may calculate the cycle for a reference time (e.g., approximately 24 hours) using the amount of change in the SOC of the battery over time.

A graph 430 of FIG. 4c may include a graph showing the change in SOC of the battery while charging and/or discharging the battery by setting the CP to 0.25.

Referring to the graph 430, it can be seen that the battery is fully charged and fully discharged in a plurality of time intervals 431, 432, and 433.

For example, the fourth time interval 431, the fifth time interval 432, and the sixth time interval 433 may be intervals having substantially the same length.

For example, when the CP is set to 0.25, it takes approximately 4 hours to fully charge the battery and about 4 hours to fully discharge the battery, and thus the fourth time interval 431, the fifth time interval 432, and the sixth time interval 433 may each be approximately 8 hours.

The processor 210 of the battery diagnosis device 200 according to an embodiment may acquire an equivalent cycle based on the amount of change in the SOC of the battery. For example, the processor 210 may identify the amount of change in SOC of the battery based on charging and/or discharging the battery using a designated value. For example, the processor 210 may acquire the equivalent cycle based on identifying the amount of change in the SOC of the battery. Specifically, the processor 210 may acquire an equivalent cycle by using the time it takes for the SOC of the battery to change from 0 to 100. In the example of FIG. 4c, the battery is fully charged and fully discharged three times during a reference time (approximately 24 hours), in which case the equivalent cycle of the battery may be 3. The processor 210 may acquire a weight corresponding to 3 corresponding to the equivalent cycle of the battery, based on the fact that the equivalent cycle of the battery is 3.

The processor 210 of the battery diagnosis device 200 according to an embodiment may predict the life of the battery based on acquiring the weight using the equivalent cycle of the battery.

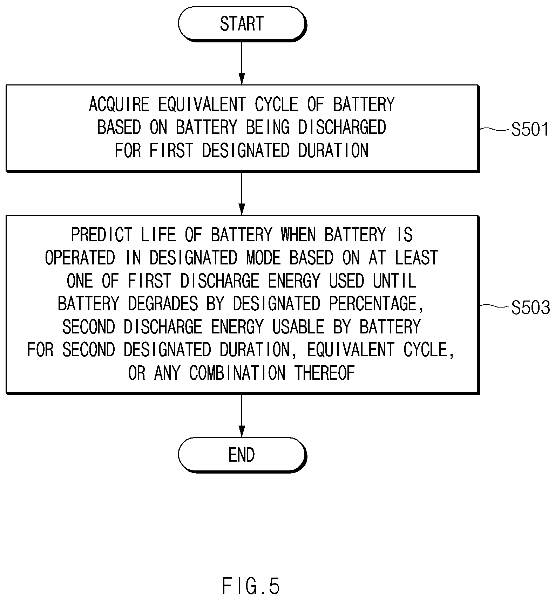

FIG. 5 illustrates an example of a flowchart related to a battery diagnosis method according to an embodiment of this document.

Hereinafter, it is assumed that the battery diagnosis device 200 of FIG. 2 performs the process of FIG. 5. In addition, in the description of FIG. 5, the operations described as being performed by the device may be understood as being controlled by the processor 210 of the battery diagnosis device 200.

At least one of the operations of FIG. 5 may be performed by the battery diagnosis device 200 of FIG. 2. At least one of the operations of FIG. 5 may be controlled by the processor 210 of FIG. 2. Each of the operations in FIG. 5 may be performed sequentially, but they are not necessarily performed sequentially. For example, the order of each operation may be changed, and at least two operations may be performed in parallel.

Referring to FIG. 5, the battery diagnosis method according to an embodiment may include, in operation S501, an operation of acquiring an equivalent cycle of the battery based on the battery being discharged for a first designated duration.

For example, the battery diagnosis method may include an operation of acquiring an equivalent cycle based on data associated with the SOC of the battery identified while the battery is discharged in the designated mode.

The battery diagnosis method according to an embodiment may include, in operation S503, may include an operation of predicting the life of the battery when the battery is operated in a designated mode based on at least one of a first discharge energy used until the battery degrades by a designated percentage, a second discharge energy usable by the battery for a second designated duration, the equivalent cycle, or any combination thereof.

For example, the battery diagnosis method may include an operation of predicting the life of the battery based on a ratio of the first discharge energy to the second discharge energy.

For example, the battery diagnosis method may include an operation of acquiring the first discharge energy based on at least one of a state of charge (SOC) of the battery, a temperature of the battery, the CP of the battery, energy of the battery, or any combination thereof.

For example, the battery diagnosis method may include an operation of acquiring the second discharge energy using a designated calculation formula.

For example, the designated mode may include a frequency regulation mode.

For example, the battery diagnosis method may include an operation of acquiring a weight for predicting the life of the battery based on the equivalent cycle associated with power used when charging or discharging the battery.

For example, the battery diagnosis method may include an operation of predicting the life based on applying the weight to the second discharge energy.

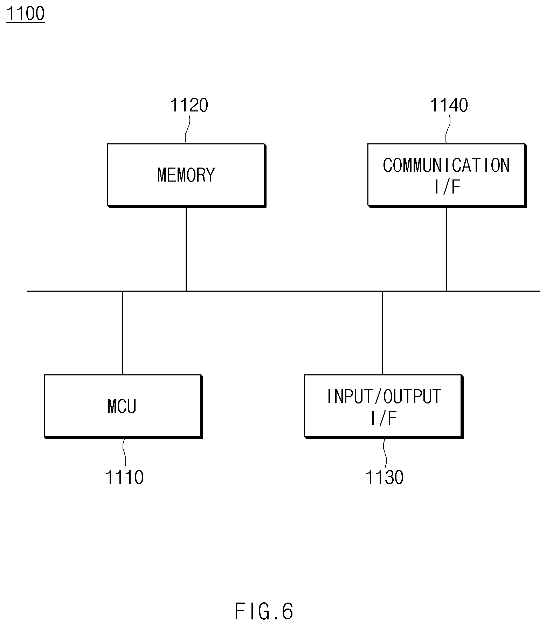

FIG. 6 is a block diagram illustrating a hardware configuration of a computing system that performs a battery diagnosis method, in a battery diagnosis device and the battery diagnosis method according to an embodiment of this document.

Referring to FIG. 6, a computing system 1100 according to an embodiment disclosed in this document may include an MCU 1110, a memory 1120, an input/output I/F 1130, and a communication I/F 1140.

The MCU 1110 may be a processor that executes various programs (e.g., battery cell data collection program, graph generation program, data analysis program, data decomposition algorithm, normalization program, and battery cell diagnosis program, etc.) stored in the memory 1220, processes various information including characteristic data of the battery cell, latent variables, etc. through these programs, and performs the functions of the battery diagnosis device 200 shown in FIGS. 1 to 5 described above.

The memory 1120 may store various programs such as the battery cell data collection program, the graph generation program, the data analysis program, the data decomposition algorithm, the normalization program, and the battery cell diagnosis program.

A plurality of such memories 1120 may be provided as needed. The memory 1120 may be a volatile memory or a nonvolatile memory. The memory 1120 used as the volatile memory may be RAM, DRAM, SRAM, etc. The memory 1120 used as the nonvolatile memory may be ROM, PROM, EAROM, EPROM, EEPROM, flash memory, etc. The examples of the memories 1120 listed above are only examples, but are not limited to these examples.

The input/output I/F 1130 may provide an interface that allows data to be transmitted and received by connecting an input device (not shown) such as a keyboard, mouse, or touch panel and an output device such as a display (not shown) with the MCU 1110.

The communication I/F 1140 is a configuration that can transmit and receive various data with the server, and may be various devices that can support wired or wireless communication. For example, the battery diagnosis device 200 may transmit and receive various information including shape models of battery cells, etc. to and from a separately provided external server through the communication I/F 1140.

In this way, the computer program according to an embodiment disclosed in this document may be implemented as a module that performs, for example, each function shown in FIG. 2, by being recorded in the memory 1120 and processed by the MCU 1110.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

**Claims**

1. A battery diagnosis device, comprising:

    a memory in which one or more instructions are stored; and
    a processor configured to execute the one or more instructions,
    wherein the processor is configured to:

        acquire an equivalent cycle of the battery based on the battery being discharged for a first designated duration; and

predict the life of the battery when the battery is operated in a designated mode based on at least one of a first discharge energy used until the battery degrades by a designated percentage, a second discharge energy usable by the battery for a second designated duration, the equivalent cycle, or any combination thereof.

2. The battery diagnosis device of claim 1, wherein the processor is configured to predict the life of the battery based on a ratio of the first discharge energy to the second discharge energy.

3. The battery diagnosis device of claim 1, wherein the processor is configured to acquire the first discharge energy based on at least one of a state of charge (SOC) of the battery, a temperature of the battery, constant power (CP) of the battery, energy of the battery, or any combination thereof.

4. The battery diagnosis device of claim 1, wherein the processor is configured to acquire the equivalent cycle based on data associated with the SOC of the battery identified while the battery is discharged in the designated mode.

5. The battery diagnosis device of claim 4, wherein the designated mode includes a frequency regulation (FR) mode.

6. The battery diagnosis device of claim 1, wherein the processor is configured to acquire a weight for predicting the life of the battery based on the equivalent cycle associated with power used when charging or discharging the battery.

7. The battery diagnosis device of claim 6, wherein the processor is configured to predict the life based on applying the weight to the second discharge energy.

8. The battery diagnosis device of claim 1, wherein the processor is configured to acquire the second discharge energy using a designated calculation formula.

9. A battery diagnosis method comprising:

an operation of acquiring, by a processor, an equivalent cycle of the battery based on the battery being discharged for a first designated duration; and

an operation of predicting, by the processor, the life of the battery when the battery is operated in a designated mode based on at least one of a first discharge energy used until the battery degrades by a designated percentage, a second discharge energy usable by the battery for a second designated duration, the equivalent cycle, or any combination thereof.

10. The battery diagnosis method of claim 9, wherein the battery diagnosis method comprises an operation of predicting, by the processor, the life of the battery based on a ratio of the first discharge energy to the second discharge energy.

11. The battery diagnosis method of claim 9, wherein the battery diagnosis method comprises an operation of acquiring, by the processor, the first discharge energy based on at least one of a state of charge (SOC) of the battery, a temperature of the battery, constant power (CP) of the battery, energy of the battery, or any combination thereof.

12. The battery diagnosis method of claim 9, wherein the battery diagnosis method comprises an operation of acquiring, by the processor, the equivalent cycle based on data associated with the SOC of the battery identified while the battery is discharged in the designated mode.

13. The battery diagnosis method of claim 12, wherein the designated mode includes a frequency regulation (FR) mode.

14. The battery diagnosis method of claim 9, wherein the battery diagnosis method comprises an operation of predicting, by the processor, the life of the battery based on the equivalent cycle associated with power used when charging or discharging the battery.

15. The battery diagnosis method of claim 14, wherein wherein the battery diagnosis method comprises an operation of predicting, by the processor, the life based on applying the weight to the second discharge energy.

FIG.1

BATTERY DIAGNOSIS DEVICE
200

PROCESSOR
210

MEMORY
220

FIG.2

SOC

TIME

310

FIG.3A

FIG.3B

SOC

TIME

410

FIG.4A

FIG.4B

FIG.4C

START

ACQUIRE EQUIVALENT CYCLE OF BATTERY
BASED ON BATTERY BEING DISCHARGED
FOR FIRST DESIGNATED DURATION

S501

PREDICT LIFE OF BATTERY WHEN BATTERY IS
OPERATED IN DESIGNATED MODE BASED ON AT LEAST
ONE OF FIRST DISCHARGE ENERGY USED UNTIL
BATTERY DEGRADES BY DESIGNATED PERCENTAGE,
SECOND DISCHARGE ENERGY USABLE BY BATTERY
FOR SECOND DESIGNATED DURATION, EQUIVALENT CYCLE,
OR ANY COMBINATION THEREOF

S503

END

FIG.5

1100

1120

MEMORY

1140

COMMUNICATION
I/F

MCU

1110

INPUT/OUTPUT
I/F

1130

FIG.6

# INTERNATIONAL SEARCH REPORT

| International application No. |
|---|
| **PCT/KR2025/013813** |

| | **A. CLASSIFICATION OF SUBJECT MATTER** |
|---|---|
| | **G01R 31/367**(2019.01)i; **G01R 31/36**(2006.01)i; **G01R 31/396**(2019.01)i; **G01R 31/392**(2019.01)i; **G01R 31/382**(2019.01)i; **H02J 7/00**(2006.01)i |

According to International Patent Classification (IPC) or to both national classification and IPC

| **B. FIELDS SEARCHED** |
|---|
| Minimum documentation searched (classification system followed by classification symbols) |
| G01R 31/367(2019.01); G01R 19/00(2006.01); G01R 31/36(2006.01); G01R 31/392(2019.01); H01M 10/48(2006.01); H02J 7/00(2006.01) |
| Documentation searched other than minimum documentation to the extent that such documents are included in the fields searched |
| Korean utility models and applications for utility models: IPC as above<br>Japanese utility models and applications for utility models: IPC as above |
| Electronic data base consulted during the international search (name of data base and, where practicable, search terms used) |
| eKOMPASS (MOIP internal) & keywords: 배터리(battery), 기간(duration), 등가 사이클(equivalent cycle), 방전 에너지(discharge energy), 진단(diagnosis) |

**C. DOCUMENTS CONSIDERED TO BE RELEVANT**

| Category* | Citation of document, with indication, where appropriate, of the relevant passages | Relevant to claim No. |
|---|---|---|
| Y<br><br>A | JP 2024-082908 A (TOSHIBA CORP.) 20 June 2024 (2024-06-20)<br>paragraphs [0013]-[0097] and figures 1-12 | 1,3-5,8-9,11-14<br><br>2,6-7,10,15 |
| Y | CN 116047311 A (HUANENG CLEAN ENERGY RESEARCH INSTITUTE et al.) 02 May 2023 (2023-05-02)<br>claim 1 | 1,3-5,8-9,11-14 |
| Y | KR 10-1839141 B1 (KOREA UNIVERSITY OF TECHNOLOGY AND EDUCATION INDUSTRY-UNIVERSITY COOPERATION FOUNDATION) 15 March 2018 (2018-03-15)<br>claim 1 | 8 |
| Y | JP 2004-264303 A (DAIMLER CHRYSLER AG) 24 September 2004 (2004-09-24)<br>paragraph [0003] | 14 |

| ✓ Further documents are listed in the continuation of Box C. | | ✓ See patent family annex. |
|---|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 December 2025** | **05 December 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2025/013813**

### C.    DOCUMENTS CONSIDERED TO BE RELEVANT

| Category* | Citation of document, with indication, where appropriate, of the relevant passages | Relevant to claim No. |
|---|---|---|
| A | KR 10-2023-0107066 A (LG ENERGY SOLUTION, LTD.) 14 July 2023 (2023-07-14) paragraphs [0024]-[0086] and figures 1-8 | 1-15 |

Form PCT/ISA/210 (second sheet) (July 2022)

EP 4 764 527 A1

## INTERNATIONAL SEARCH REPORT
### Information on patent family members

International application No.

**PCT/KR2025/013813**

| Patent document cited in search report | | | Publication date (day/month/year) | Patent family member(s) | | | Publication date (day/month/year) |
|---|---|---|---|---|---|---|---|
| JP | 2024-082908 | A | 20 June 2024 | EP | 4382939 | A1 | 12 June 2024 |
| | | | | JP | 7767261 | B2 | 11 November 2025 |
| | | | | US | 2024-0195198 | A1 | 13 June 2024 |
| CN | 116047311 | A | 02 May 2023 | CN | 116047311 | B | 13 June 2023 |
| | | | | WO | 2024-183743 | A1 | 12 September 2024 |
| KR | 10-1839141 | B1 | 15 March 2018 | US | 10211487 | B2 | 19 February 2019 |
| | | | | US | 2018-0123185 | A1 | 03 May 2018 |
| JP | 2004-264303 | A | 24 September 2004 | EP | 1450173 | A2 | 25 August 2004 |
| | | | | EP | 1450173 | A3 | 22 July 2009 |
| | | | | US | 2005-0001625 | A1 | 06 January 2005 |
| | | | | US | 7554330 | B2 | 30 June 2009 |
| KR | 10-2023-0107066 | A | 14 July 2023 | CN | 118284817 | A | 02 July 2024 |
| | | | | EP | 4425198 | A1 | 04 September 2024 |
| | | | | EP | 4425198 | B1 | 12 November 2025 |
| | | | | JP | 2025-502012 | A | 24 January 2025 |
| | | | | US | 2025-0012862 | A1 | 09 January 2025 |
| | | | | WO | 2023-132520 | A1 | 13 July 2023 |

Form PCT/ISA/210 (patent family annex) (July 2022)

22

**REFERENCES CITED IN THE DESCRIPTION**

**Patent documents cited in the description**

- KR 1020240121713